# EUROPÄISCHE PATENTSCHRIFT

(11) **EP 2 725 597 B1**
(45) Veröffentlichungstag und Bekanntmachung des Hinweises auf die Patenterteilung: **04.03.2015**
(21) Anmeldenummer: 12007440.6
(22) Anmeldetag: 29.10.2012
(51) Int. Cl.: H01H 11/00, H02B 13/065, H01H 33/86

(54) **Verfahren zur Diagnose eines Selbstblasschalters und Diagnosevorrichtung**
Method for diagnosing a self-blowing switch and diagnostic device
Procédé de diagnostic d'un commutateur à auto-extinction et dispositif de diagnostic

(43) Veröffentlichungstag der Anmeldung: 30.04.2014
(73) Patentinhaber: Omicron electronics GmbH, 6833 Klaus (AT)
(72) Erfinder: Kurz, Andreas, 60437 Frankfurt (DE); Hoffacker, Matthias, 52066 Aachen (DE); Schnettler, Armin, 52076 Aachen (DE); Hille, Christian, 52062 Aachen (DE)
(74) Vertreter: Meier, Florian

(56) Entgegenhaltungen:
- WO-A1-93/23760
- DE-A1- 19 604 203
- US-A- 5 636 134
- US-A- 6 023 404

## Beschreibung

Die Erfindung betrifft Verfahren und Vorrichtungen zur Diagnose von Leistungsschaltern. Die Erfindung betrifft insbesondere Verfahren und Vorrichtungen, mit denen der Zustand einer Abbranddüse eines Selbstblasschalters ermittelt werden kann.

Leistungsschalter sind Sicherheitselemente, die derzeit im Bereich der Mittel- und Hochspannung in Wechselspannungsnetzen zur Unterbrechung von Nenn- und Kurzschlussströmen eingesetzt werden können. Die Leistungsschaltertechnologie kann auch in Gleichstromnetzen eingesetzt werden. Leistungsschalter können beispielsweise als Vakuum-Leistungsschalter oder als gasgefüllte Leistungsschalter ausgestaltet sein. In der Hochspannungsebene werden häufig gasgefüllte Leistungsschalter eingesetzt. Das Füllgas kann beispielsweise Schwefelhexafluorid (SF₆) als Isolier- und Löschgas aufweisen.

Ein Leistungsschalter weist zumeist zwei Schaltkontakte auf, die im geschlossenen Zustand des Schalters miteinander in Kontakt stehen. Zum Ausschalten werden die beiden Kontakte voneinander weg bewegt, wobei sich ein zwischen den Kontakten brennender Lichtbogen ausbildet. Entscheidend für ein erfolgreiches Abschalten des Stromes ist es, diesen Lichtbogen zwischen den Schaltkontakten zum Verlöschen zu bringen. Dazu wird bei Kolbenblasschaltern und bei Selbstblasschaltern der Lichtbogen mit einem den Lichtbogen kühlenden Lösch- und Isoliergas beblasen. Das Füllgas, mit dem der Kolbenblasschalter oder Selbstblasschalter gefüllt ist, kann teilweise oder vollständig aus dem Löschgas bestehen. Dieses Gas muss einerseits dazu in der Lage sein, den Lichtbogen abzukühlen und zum Verlöschen zu bringen, und sollte nach dem Verlöschen des Lichtbogens eine Rückzündung bzw. Wiederzündung zwischen den Kontakten unterbinden.

In Selbstblasschaltern wird die im Lichtbogen umgesetzte Energie dazu genutzt, um den zum Beblasen des Lichtbogens notwendigen Gasdruck aufzubauen. Der Lichtbogen zwischen den Schaltkontakten kann hierbei während des Abschaltvorganges in Abbranddüsen aus einem Isoliermaterial wie Polytetrafluorethylen (PTFE) oder einem anderen geeigneten Material geführt werden, welches unter dem Einfluss des Lichtbogens verdampft und somit einen Überdruck des Gases erhöht. In heutigen Hochspannungsnetzen finden Selbstblasschaltern mit Schwefelhexafluorid (SF₆) als lsoliermedium weiten Einsatz.

Hersteller von Leistungsschaltern schreiben in ihren Instandhaltungsrichtlinien vor, den Gasraum eines Selbstblasschalters in bestimmten Intervallen oder nach einer bestimmten Anzahl an Schaltspielen zu öffnen. Den Grund hierfür stellt die Kontrolle des Abbrands von Kontakt- und Düsensystemen dar. In der Vergangenheit konnte mit der dynamischen Widerstandsmessung ein verlässliches Verfahren zur Bestimmung des Kontaktabbrands etabliert werden. Dennoch müssen herkömmlich die Selbstblasschalter zur Kontrolle des Düsenabbrands der Abbranddüse aus Isolierstoff geöffnet werden.

Dies bringt mehrere Nachteile für den Betreiber des Selbstblasschalters mit sich. Das Öffnen des Selbstblasschalters ist zeit- und arbeitsaufwändig und führt somit zu hohen Kosten. Weiterhin muss die Schaltanlage, in der der Selbstblasschalter eingesetzt wird, teilweise außer Betrieb genommen werden. Nach dem Öffnen des Gehäuses eines Selbstblasschalters kann eine erhöhte Störanfälligkeit zu verzeichnen sein, die aus dem Risiko einer fehlerhaften Remontage oder durch das Einbringen von Fremdstoffen begründet sein kann.

Eine nicht-invasive und zuverlässige Methode zur Bestimmung des Düsenabbrands könnte ein Öffnen der Schaltkammer hinauszögern oder sogar ganz vermeiden. Ein Ansatz zur nicht-invasiven Bestimmung des Düsenabbrands kann in der Messung einer Frequenzantwort bestehen. Dabei kann der Selbstblasschalter als Testobjekt einem elektrischen oder mechanischen Signal als Stimulus ausgesetzt und seine Reaktion im Rahmen einer Frequenzantwort-Analyse ("Frequency Response Analysis", FRA) bestimmt werden. Auf diese Weise kann beispielsweise der Abbrand von Düsenmaterial bestimmt werden. Die Realisierung eines derartigen Ansatzes ist jedoch aufwändig. Die Realisierung kann insbesondere im Feldeinsatz mit Schwierigkeiten verbunden sein.

Eine weiterer Ansatz zur nicht-invasiven Bestimmung des Düsenabbrands ist die zeitlich aufgelöste Messung der im Netz auftretenden Ströme, um mit Hilfe von Simulationen anschließend den beim vorliegenden Strom auftretenden Düsenabbrand zu berechnen. Die Realisierung dieses Ansatzes würde jedoch eine flächendeckende Ausstattung der vorhandenen Schutz- und Leittechnik mit entsprechenden Einheiten zur Datenerfassung und Datenspeicherung erfordern, was zu erheblichem Installationsaufwand und zu erheblichen Installationskosten führen würde.

Methoden zur Überwachung von Leistungsschaltern, wie sie beispielsweise in der DE 196 04 203 A1 beschrieben sind, sind auf die Beobachtung der Antriebsvorrichtung bzw. des beweglichen Kontakts des Leistungsschalters beschränkt und erlauben keine Rückschlüsse auf den Düsenabbrand.

US 5 636 134 A beschreibt ein Verfahren, wobei der Düsenverschleiß ermittelt wird und der Druckverlauf erfasst wird.

Es besteht somit weiterhin Bedarf an Verfahren und Vorrichtungen, mit denen ein Düsenabbrand abgeschätzt werden kann, ohne dass die Schaltkammer des Selbstblasschalters geöffnet werden muss. Es besteht insbesondere ein Bedarf an derartigen Verfahren und Vorrichtungen, die sich einfach in bestehende Instandhaltungstätigkeiten einbinden lassen und nur einen geringen zusätzlichen Kosten- und Zeitaufwand mit sich bringen.

Aufgabe der Erfindung ist es, Verfahren und Vorrichtungen anzugeben, die Verbesserungen im Hinblick auf die beschriebenen Probleme bieten.

Es werden ein Verfahren und eine Vorrichtung mit den in den unabhängigen Ansprüchen angegebenen Merkmalen bereitgestellt. Die abhängigen Ansprüche definierten vorteilhafte oder bevorzugte Ausführungsformen.

Bei einem Verfahren zur Diagnose eines Selbstblasschalters wird ein Schaltvorgang des Selbstblasschalters ausgelöst, um eine Druckwelle in einem Füllgas des Selbstblasschalters auszulösen. Ein zeitabhängiger Druckverlauf, der in wenigstens einem Bereich des Selbstblasschalters als Reaktion auf den Schaltvorgang auftritt, wird erfasst. Ein Zustand einer Abbranddüse des Selbstblasschalters, die bei einem Schaltvorgang unter Last zum Beblasen eines Schaltlichtbogens mit dem Füllgas abgebrannt wird, wird in Abhängigkeit von dem zeitabhängigen Druckverlauf ermittelt.

Bei dem Verfahren wird aus dem zeitabhängigen Druckverlauf auf den Zustand der Abbranddüse rückgeschlossen. Die Erfassung des Druckverlaufs kann erfolgen, ohne dass der Selbstblasschalter dazu demontiert und/oder die Schaltkammer geöffnet werden muss. Der zur Messung notwendige Druckaufbau kann durch die Kompression eines Volumens im Schalter selbst, beispielsweise unter Wirkung des Antriebs des Selbstblasschalters oder auf andere Art und Weise erzeugt werden. Dabei wird der transiente Druckverlauf durch einen Strömungswiderstand des Düsensystems beeinflusst. Die Erfassung des Druckverlaufs kann am montierten Selbstblasschalter erfolgen, so dass das Verfahren zeiteffizient und kostengünstig durchgeführt werden kann. Der Leistungsschalter ist lediglich für eine kurze Zeitdauer, in der der Selbstblasschalter gewartet wird, freizuschalten. Die Geometrie der Abbranddüse beeinflusst Druckwellen, beispielsweise Schallwellen, die sich in dem Füllgas nach einem Schaltvorgang ohne elektrische Last ausbreiten, so dass anhand des Druckverlaufs zuverlässig ermittelt werden kann, ob der Abbrand der Abbranddüse so stark ist, dass eine Demontage des Selbstblasschalters erforderlich ist.

Der Zustand der Abbranddüse kann abhängig von einer transienten Druckveränderung, die als Reaktion auf den Schaltvorgang in einem Zeitintervall erfasst wird, bestimmt werden. Die Druckveränderung variiert in Abhängigkeit vom Düsenabbrand. Als Messposition kann der vorhandene Anschluss zur Gasbefüllung genutzt werden. Somit kann die Überprüfung des Düsensystems im Rahmen einer Standard-Wartung direkt vor Ort durchgeführt werden.

Der zeitabhängige Druckverlauf kann an einer Füllöffnung des Selbstblasschalters erfasst werden, die von der Abbranddüse beabstandet ist. Diese ist auch im montierten Zustand des Selbstblasschalters gut zugänglich. Die Messung kann erfolgen, ohne dass eine Modifikation der Leistungsschalter notwendig ist.

Der Schaltvorgang, mit dem die Druckwelle ausgelöst wird, kann ohne elektrische Last durchgeführt werden.

Die Messung und Auswertung kann automatisch mit einer Diagnosevorrichtung durchgeführt werden, ohne dass der Selbstblasschalter dazu ausgebaut und in eine Messlabor verbracht werden muss. Die Messung und Auswertung kann mit einer kompakten, mobilen Diagnosevorrichtung durchgeführt werden. Ein Drucksensor der mobilen Diagnosevorrichtung kann an dem Selbstblasschalter entfernbar so montiert werden, dass er den Druckverlauf erfasst.

Bei dem Verfahren kann eine Kontakttrennung von Kontakten des Selbstblasschalters erfasst werden. Das Zeitintervall, in dem die transiente Druckveränderung ausgewertet wird, um Informationen über den Düsenabbrand zu erhalten, kann abhängig von einem Zeitpunkt, bei dem die Kontakttrennung erfolgt, festgelegt werden. Alternativ oder zusätzlich kann die Datenerfassung des Druckverlaufs abhängig vom dem Zeitpunkt, bei dem die Kontakttrennung erfolgt, festgelegt werden.

Zum Erfassen der Kontakttrennung kann ein mechanischer Antrieb des Selbstblasschalters überwacht werden. Dazu kann ein Drehwinkelsensor an einer Antriebswelle des Selbstblasschalters montiert werden.

Bei dem Verfahren können ein Druck und eine Temperatur des Füllgases vor dem Auslösen des Schaltvorgangs erfasst werden. Das Zeitintervall, in dem die transiente Druckveränderung ausgewertet wird, um Informationen über den Düsenabbrand zu erhalten, kann abhängig von dem erfassten Druck und der erfassten Temperatur des Füllgases festgelegt werden. Auf diese Weise kann die Schallgeschwindigkeit bzw. eine Variation der Schallgeschwindigkeit im Füllgas berücksichtigt werden. Die Schallgeschwindigkeit beeinflusst das Zeitintervall, in dem von der Geometrie der Abbranddüse beeinflusste Druckveränderungen an einer Messposition, beispielsweise an der Füllöffnung des Selbstblasschalters, detektierbar sind. Das Zeitintervall kann weiterhin abhängig von der Geometrie des Selbstblasschalters festgelegt werden, um den Abstand zwischen Abbranddüse und Messposition zur berücksichtigen.

Der Zustand der Abbranddüse kann abhängig von einem Zeitintegral der erfassten transienten Druckveränderung ermittelt werden. Da bereits ein Vorzeichen der Druckveränderung vom Düsenabbrand abhängen kann, kann auf diese Weise durch einfache Verarbeitung der Zustand der Abbranddüse zuverlässig bestimmt werden.

Der Zustand der Abbranddüse kann abhängig von einer Spektralkomponente des erfassten zeitabhängigen Druckverlaufs ermittelt werden. Der Druckverlauf, der in einem Zeitintervall nach Auslösen des Schaltvorgangs erfasst wird, kann einer Spektralanalyse unterzogen werden. Beispielsweise kann eine Fouriertransformation vorgenommen werden. Alternativ oder zusätzlich kann der Druckverlauf einer Filterung unterzogen werden, um unerwünschte Signalbeiträge zu unterdrücken, die beispielsweise durch Reflexionen von Schallwellen zwischen den Seitenwänden des Selbstblasschalters hervorgerufen werden können.

Die Ermittlung des Zustands der Abbranddüse kann automatisch und rechnergestützt erfolgen. Dazu kann über eine Benutzerschnittstelle einer Diagnosevorrichtung durch eine Benutzereingabe der Bautyp des Selbstblasschalters und/oder andere Informationen, die den Selbstblasschalter identifizieren, eingegeben werden. Eine oder mehrere Kenngrößen, die von dem erfassten Druckverlauf abhängen, können mit in einer Datenbank für den Bautyp hinterlegten Kenngrößen verglichen werden, um den Zustand der Abbranddüse zu ermitteln. Bei einer Ausgestaltung kann für jeden Bautyp eine Mehrzahl von zeitabhängigen Druckverlaufskurven in der Datenbank hinterlegt sein. Der am Selbstblasschalter erfasste Druckverlauf kann mit den hinterlegten Druckverlaufskurven verglichen werden, um zu bestimmen, ob der Abbrand der Abbranddüse so weit fortgeschritten ist, dass eine Sichtprüfung oder ein Austausch des Selbstblasschalters erforderlich ist. Bei einer weiteren Ausgestaltung kann eine Spektralkomponente des erfassten Druckverlaufs mit einem oder mehreren in der Datenbank für diesen Bautyp hinterlegten Schwellenwerten verglichen werden. Auf diese Weise kann bestimmt werden, ob der Abbrand der Abbranddüse so weit fortgeschritten ist, dass eine Sichtprüfung oder ein Austausch des Selbstblasschalters erforderlich ist.

Der ermittelte Zustand der Abbranddüse kann ausgewählt sein aus einer Gruppe, die einen ersten Zustand, der einen weiteren Betrieb des Selbstblasschalters erlaubt, und einen zweiten Zustand, der eine Sichtüberprüfung der Abbranddüse des Selbstblasschalters erfordert, umfasst.

Das Verfahren kann mit einer Diagnosevorrichtung, insbesondere einer mobilen Diagnosevorrichtung, am montierten Selbstblasschalter durchgeführt werden. Das Verfahren kann nicht-invasiv durchgeführt werden, ohne dass die Schaltkammer des Selbstblasschalters geöffnet wird.

Nach einer weiteren Ausführungsform wird eine Diagnosevorrichtung für Selbstblasschalter angegeben. Die Diagnosevorrichtung umfasst eine Schnittstelle zum Empfangen von Druckdaten, die einen zeitabhängigen Druckverlauf in wenigstens einem Bereich des Selbstblasschalters als Reaktion auf einen Schaltvorgang des Selbstblasschalters angeben. Die Diagnosevorrichtung umfasst eine Steuerung, die mit der Schnittstelle gekoppelt ist und die eingerichtet ist, um einen Zustand einer Abbranddüse des Selbstblasschalters, die bei einem Schaltvorgang unter Last abgebrannt wird, in Abhängigkeit von den Druckdaten zu ermitteln. Die Diagnosevorrichtung kann als mobile Diagnosevorrichtung ausgestaltet sein.

Die mit der Diagnosevorrichtung erzielten Wirkungen entsprechen den mit dem Verfahren erzielten Wirkungen.

Die Diagnosevorrichtung kann einen mit der Schnittstelle lösbar koppelbaren Drucksensor umfassen. Der Drucksensor kann eine Kopplungsstruktur aufweisen, die zur Befestigung an einer Füllöffnung des Selbstblasschalters eingerichtet ist.

Die Diagnosevorrichtung kann einen weiteren Sensor oder mehrere weitere Sensoren zum Überwachen einer Kontakttrennung umfassen. Beispielsweise kann die Diagnosevorrichtung einen Drehwinkelsensor zum Erfassen eines Drehwinkels einer Antriebswelle des Selbstblasschalters umfassen. Die Diagnosevorrichtung kann weitere Sensorik zur Erfassung der Kontakttrennung umfassen. Beispielsweise kann die Unterbrechung eines schwachen Stroms durch den Schalter genutzt bzw. überwacht werden. Die Steuerung ist mit dem weiteren Sensor gekoppelt und eingerichtet, um abhängig von einer Druckveränderung in einem Zeitintervall, das von einem Zeitpunkt der Kontakttrennung abhängt, den Zustand der Abbranddüse zu ermitteln.

Die Diagnosevorrichtung kann einen Speicher umfassen, mit dem die Steuerung gekoppelt ist. Der Speicher kann für eine Mehrzahl von Bautypen von Selbstblasschaltern jeweils Informationen zu einem zeitabhängigen Druckverlauf nach Auslösen eines Schaltvorgangs enthalten, anhand derer die Steuerung den am Selbstblasschalter erfasste Druckverlauf automatisch bewertet.

Die Diagnosevorrichtung kann zur Durchführung des Verfahrens nach einem Ausführungsbeispiel eingerichtet sein. Dabei kann die Steuerung die verschiedenen Auswerteschritte des Verfahrens durchführen, um anhand des erfassten Druckverlaufs zu bestimmen, ob der Abbrand der Abbranddüse so weit fortgeschritten ist, dass eine Sichtprüfung oder ein Austausch des Selbstblasschalters erforderlich ist.

Der Schaltvorgang, der zum Auslösen einer Druckwelle in dem Füllgas ausgelöst wird, kann den Selbstblasschalter von einem geschlossenen Zustand in einen offenen Zustand überführen. Der Schaltvorgang kann von der Diagnosevorrichtung ausgelöst werden.

Verfahren und Vorrichtungen zur Diagnose von Selbstblasschaltern können eingesetzt werden, um Leistungsschalter in Mittelspannungsnetzen und Hochspannungsnetzen zu überprüfen.

Die Erfindung wird nachfolgend unter Bezugnahme auf die Zeichnungen anhand bevorzugter Ausführungsformen erläutert.
FIG. 1 ist eine schematische Darstellung eines Selbstblasschalters mit einer mobilen Diagnosevorrichtung nach einem Ausführungsbeispiel.
FIG. 2 zeigt eine Schnittansicht einer Löschkammer des Selbstblasschalters zur Erläuterung eines Verfahrens nach einem Ausführungsbeispiel.
FIG. 3 zeigt eine vergrößerte Ansicht eines Teils der Löschkammer in einem Zustand ohne Düsenabbrand.
FIG. 4 zeigt eine vergrößerte Ansicht des Teils der Löschkammer in einem Zustand mit stärkerem Düsenabbrand.
FIG. 5 zeigt Druckverläufe, die bei Verfahren und mobilen Diagnosevorrichtungen nach Ausführungsbeispielen ausgewertet werden, um einen Zustand einer Abbranddüse zu ermitteln.
FIG. 6 zeigt Druckverläufe, die bei Verfahren und mobilen Diagnosevorrichtungen nach Ausführungsbeispielen ausgewertet werden, um einen Zustand einer Abbranddüse zu ermitteln.
FIG. 7 zeigt Druckverläufe, die bei Verfahren und mobilen Diagnosevorrichtungen nach Ausführungsbeispielen ausgewertet werden, um einen Zustand einer Abbranddüse zu ermitteln.
FIG. 8 zeigt Druckverläufe für unterschiedliche Geschwindigkeiten eines Kontaktstiftes ohne Düsenabbrand.
FIG. 9 zeigt Druckverläufe für unterschiedliche Geschwindigkeiten eines Kontaktstiftes bei stärkerem Düsenabbrand.
FIG. 10 ist ein Flussdiagramm eines Verfahrens nach einem Ausführungsbeispiel.

In den Figuren bezeichnen ähnliche oder identische Bezugszeichen ähnliche oder identische Elemente.

Während Verfahren und Diagnosevorrichtungen nach Ausführungsbeispielen anhand von Selbstblasschaltern mit beispielhaften Konfigurationen erläutert werden, können die Verfahren und Diagnosevorrichtungen bei Selbstblasschaltern mit einer Vielzahl anderer Konfigurationen eingesetzt werden. Die dargestellten Konfigurationen von Selbstblasschaltern sind nur veranschaulichend für Wirkprinzipien von Selbstblasschaltern zu verstehen. Der Begriff "Selbstblasschalter" wird hier synonym zu den in der Technik ebenfalls gebräuchlichen Begriffen "Selbstblasleistungsschalter" oder "Selbstbläser" verwendet.

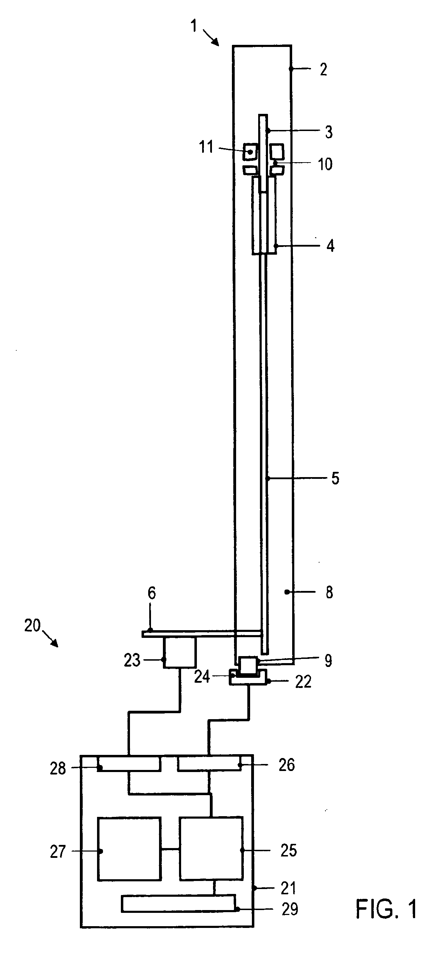

FIG. 1 ist eine schematische Darstellung eines Selbstblasschalters 1 mit einer mobilen Diagnosevorrichtung 20 nach einem Ausführungsbeispiel. Der Selbstblasschalter 1 ist ein Leistungsschalter für ein Mittelspannungsnetz oder ein Hochspannungsnetz. Auch wenn nur ein Selbstblasschalter 1 dargestellt ist, können mehrere Selbstblasschalter in einer kombinierten Anordnung oder "Batterie" von Selbstblasschaltern kombiniert sein. In diesem Fall kann die mobile Diagnosevorrichtung 20 automatisch die beschriebenen Diagnosefunktionen zur Bestimmung eines Düsenabbrands für jeden der mehreren Selbstblasschalter durchführen.

Der Selbstblasschalter 1 weist ein Gehäuse 2 auf. In dem Gehäuse sind ein erster Kontakt 3 und ein zweiter Kontakt 4 vorgesehen. Im geschlossenen Zustand des Selbstblasschalters 1 stehen der erste Kontakt 3 und der zweite Kontakt 4 miteinander in Kontakt. Um den Selbstblasschalter 1 in den offenen Zustand zu versetzen, wird wenigstens einer der Kontakte bewegt. Mechanische Komponenten wie eine Antriebsstange 5, die über ein Getriebe mit einem Motor gekoppelt ist, sind vorgesehen. Eine Antriebswelle 6 kann über die Antriebsstange 5 eine Bewegung eines der Kontakte hervorrufen, um den Selbstblasschalter 1 in den offenen Zustand zu überführen. Beispielsweise kann der zweite Kontakt 4, der als Fingerkontakt geformt sein kann, zusammen mit einer Abbranddüse 11 relativ zu dem ersten Kontakt 3 bewegt werden, der ein feststehender Kontaktstift sein kann.

Der Selbstblasschalter 1 ist als gasgefüllte Leistungsschalter ausgestaltet. Ein Füllgas ist in einem Innenraum 8 des Gehäuses 2 enthalten. Als Füllgas kann beispielsweise Schwefelhexafluorid (SF₆) eingesetzt werden, oder das Füllgas kann zu einem wesentlichen Teil aus Schwefelhexafluorid bestehen. Andere Isolier- und Löschgase können verwendet werden. Wenn der in einem Zustand, in dem der Selbstblasschalter 1 unter elektrischer Last steht, der Selbstblasschalter 1 in einen offenen Zustand überführt wird, löscht das Füllgas einen zwischen dem ersten Kontakt 3 und dem zweiten Kontakt 4 brennenden Lichtbogen. Dazu wird der Lichtbogen mit dem Füllgas bzw. einer Mischung aus dem Füllgas und dem Gas, das durch Düsenabbrand entsteht beblasen. Das Füllgas kann über eine Öffnung 10, die sich in der Nähe der Stelle befindet, an der der Lichtbogen brennt, auf den Lichtbogen geblasen werden. Für einen effizienten Druckaufbau ist bei dem Selbstblasschalter 1 die Abbranddüse 11 vorgesehen. Die Abbranddüse 11 ist aus einem Isoliermaterial bzw. Isolierstoff gebildet, das bzw. der unter Einfluss des Lichtbogens teilweise verdampft. Dieser Vorgang wird auch als "Abbrennen" oder "Abbrand" der Abbranddüse 11 bezeichnet. Der resultierende Partialdruck kann zum Beblasen des Lichtbogens mit dem Füllgas eingesetzt werden. Die Abbranddüse 11 kann beispielsweise aus Polytetrafluorethylen (PTFE) oder einem anderen geeigneten Isolierstoff gebildet sein.

Für Wartungsarbeiten weist der Selbstblasschalter 1 eine Füllöffnung 9 auf, über die Füllgas nachgefüllt werden kann. Wenn mehrere Selbstblasschalter in einer Batterie von Selbstblasschaltern kombiniert sind, kann eine gemeinsame Füllöffnung 9 vorgesehen sein. Die Füllöffnung 9 kann an einem sich quer zu einer Längsachse des Selbstblasschalters 1 erstreckenden Gehäuseabschnitt vorgesehen sein. Die Füllöffnung 9 kann beabstandet von einer Löschkammer, die den Kontaktbereich des ersten Kontakts 3 und des zweiten Kontakts 4 umgibt, vorgesehen sein.

Die Verwendung von Selbstblasschaltern als Leistungsschalter hat im Vergleich zu herkömmlichen Kolbenblasschaltern den Vorteil, dass ein schwächerer Antrieb verwendet werden kann. Der durch die Verdampfung der Abbranddüse 11 erzeugte zusätzliche Überdruck, der zum Beblasen des Lichtbogens mit dem Füllgas verwendet wird, spart Antriebsenergie für die Kompression des Füllgases. Allerdings muss sichergestellt sein, dass die Abbranddüse 11 nur so weit abbrennt, dass bei einem erneuten Schaltvorgang noch ausreichend Material der Abbranddüse 11 verdampfen kann. Darüber hinaus sollte für einen effizienten Druckaufbau im Heizvolumen ein so genanntes "Clogging" (Verstopfen) der Düse auftreten, was bei einem zu großen Düsendurchmesser im Vergleich zum fließenden Strom nicht mehr möglich ist. Es muss somit auch sichergestellt sein, dass die Abbranddüse 11 nur so weit abbrennt, dass noch ein effizienter Druckaufbau beim Heizen möglich ist.

Um den Abbrandstatus der Abbranddüse 11 nicht-invasiv bestimmen zu können, wird bei Ausführungsbeispielen der Erfindung ein transienter Druckverlauf erfasst und ausgewertet, wenn der Selbstblasschalter 1 ohne elektrische Last in den offenen Zustand geschaltet wird. Dabei bilden sich im Inneren des Selbstblasschalters 1 Druckwellen aus, die sich mit Schallgeschwindigkeit durch das Füllgas bewegen. Diese Druckwellen werden durch die Geometrie der Abbranddüse 11 beeinflusst. Durch Aufzeichnung des transienten Druckverlaufs an einer Messposition, beispielsweise an der Füllöffnung 9, und durch anschließende Auswertung kann auf den Zustand der Abbranddüse zurückgeschlossen werden.

Zur Erfassung des transienten Druckverlaufs, der als Reaktion auf einen Schaltvorgang an der Füllöffnung 9 auftritt, wird eine mobile Diagnosevorrichtung 20 verwendet. Wie nachfolgend näher beschrieben wird, wird mit der mobilen Diagnosevorrichtung 20 ein transienter Druckverlauf erfasst, der an einer Messposition auftritt, wenn der Selbstblasschalter 1 ohne elektrische Last in den offenen Zustand geschaltet wird. Der transiente Druckverlauf wird ausgewertet, um einen Zustand der Abbranddüse 11 zu ermitteln. Zum Ermitteln des Zustands kann abhängig von dem Druckverlauf bestimmt werden, ob die Abbranddüse 11 bereits soweit abgebrannt ist, dass ein Öffnen des Gehäuses 2 des Selbstblasschalters erforderlich ist, um Zugang zur Schaltkammer zu erhalten.

Die mobile Diagnosevorrichtung 20 kann einen Drucksensor 22 umfassen. Der Drucksensor 22 kann an der Füllöffnung 9 angebracht sein, die als Gasanschluss ausgestaltet sein kann. Der Drucksensor 22 weist mechanische Kopplungselemente 24 auf, die eine mechanische Befestigung an der Füllöffnung 9 erlauben. Die mechanischen Kopplungselemente können so an die Geometrie der Füllöffnung angepasst sein, dass eine mechanische Befestigung an der Füllöffnung 9 möglich ist. Der Drucksensor 22 ist so ausgestaltet, dass er im an der Füllöffnung 9 montierten Zustand einen Druck erfasst, der im Inneren des Gehäuses 2 an der Füllöffnung 9 herrscht. Der Drucksensor 22 kann so ausgestaltet sein, dass er eine Antwortzeit aufweist, die eine zeitaufgelöste Druckerfassung mit einer hohen zeitlichen Auflösung, beispielsweise mit einer zeitlichen Auflösung von einigen Millisekunden, gewährleistet. Falls die Füllöffnung 9 mit einem Rückschlagventil versehen ist, weist der Drucksensor 22 Elemente auf, die durch Öffnen des Rückschlagventils sicherstellen, dass der Drucksensor 22 den im Inneren des Gehäuses 2 an der Füllöffnung 9 herrschenden Druck erfassen kann. Der Drucksensor 22 ist mit einer Schnittstelle 26 eines mobilen Messgeräts 21 gekoppelt. Der Drucksensor 22 kann lösbar mit der Schnittstelle 26 des mobilen Messgeräts 21 gekoppelt sein.

Die mobile Diagnosevorrichtung 20 umfasst das mobile Messgerät 21. Das mobile Messgerät 21 kann als tragbarer Computer ausgestaltet sein, der programmtechnisch eingerichtet ist, um den im Inneren des Gehäuses 2 herrschenden zeitabhängigen Druckverlauf auszuwerten, um den Zustand der Abbranddüse 21 zu bestimmen. Das mobile Messgerät 21 weist eine Steuerung 25 auf, die einen oder mehrere Prozessoren umfassen kann. Die Steuerung 25 ist mit der Schnittstelle 26 gekoppelt, um von dem Drucksensor 22 ein Signal oder Daten zu empfangen, die den Druckverlauf an der Füllöffnung 9 angeben. Die Steuerung 25 verarbeitet die Daten, um einen Druckverlauf in einem Zeitintervall nach dem Schaltvorgang auszuwerten. Das Zeitintervall kann beispielsweise eine Dauer von einigen Millisekunden, einigen zehn Millisekunden oder einigen hundert Millisekunden aufweisen. Die Steuerung 25 kann unterschiedliche Verarbeitungsschritte vornehmen, um aus dem erfassten Druckverlauf automatisch Rückschlüsse auf den Zustand der Abbranddüse 11 zu ziehen. Dazu kann die Steuerung 25 beispielsweise eine Druckveränderung in einem Zeitintervall integrieren oder Spektralkomponenten des Druckverlaufs rechnerisch bestimmen. Alternativ oder zusätzlich kann die Steuerung 25 den als Funktion der Zeit erfassten Druckverlauf mit einer oder mehreren Referenzkurven vergleichen. Abhängig von der Auswertung des Druckverlaufs kann die Steuerung 25 automatisch bestimmen, ob der Abbrand der Abbranddüse so weit fortgeschritten ist, dass die Schaltkammer des Selbstblasschalters 1 geöffnet werden muss, um die Abbranddüse 11 einer Sichtprüfung zu unterziehen.

Das mobile Messgerät 21 kann eine Benutzerschnittstelle 29 aufweisen. Ein Ergebnis der Auswertung des Druckverlaufs kann von der Steuerung 25 über die Benutzerschnittstelle 29 ausgegeben und/oder in einem Speicher 27 des mobilen Messgeräts 21 gespeichert werden.

Um zu berücksichtigen, dass Selbstblasschalter mit unterschiedlicher Geometrie und Ausgestaltung existieren, kann der Benutzer über die Benutzerschnittstelle 29 Informationen eingeben, die den Selbstblasschalter 1 betreffen und die von der Steuerung 25 bei der automatischen Auswertung des erfassten Druckverlaufs herangezogen werden. Beispielsweise kann das mobile Messgerät 21 so ausgestaltet sein, dass der Benutzer über die Benutzerschnittstelle 29 eine Modellbezeichnung des Selbstblasschalters angeben kann, beispielsweise durch Auswahl aus einer vorgegebenen Gruppe von Modellen. Der Speicher 27 enthält für die unterschiedlichen Modelle bzw. Bautypen jeweils Referenzdaten, anhand derer die Steuerung 25 den erfassten Druckverlauf bewerten kann, um den Zustand der Abbranddüse 11 zu ermitteln. Die in dem Speicher 27 hinterlegten Referenzdaten können abhängig von der Verarbeitung des erfassten Druckverlaufs, der von der Steuerung 25 vorgenommen wird, unterschiedliche Formate aufweisen. Falls beispielsweise die Steuerung 25 aus dem erfassten Druckverlauf durch zeitliche Integration oder Spektralanalyse des Druckverlaufs eine einzige Kenngröße ermittelt, kann in dem Speicher 27 für jeden von mehreren Bautypen jeweils ein Schwellenwert hinterlegt sein. Abhängig von einem Vergleich der aus dem Druckverlauf ermittelten Kenngröße mit dem Schwellenwert kann die Steuerung 25 automatisch bestimmen, ob der Abbrand der Abbranddüse 11 so weit fortgeschritten ist, dass das Gehäuse 2 des Selbstblasschalters geöffnet werden muss. Falls die Steuerung 25 aus dem erfassten Druckverlauf beispielsweise durch Spektralanalyse des Druckverlaufs mehrere Kenngrößen ermittelt, die den Spektralkomponenten entsprechen können, kann in dem Speicher 27 für jeden von mehreren Bautypen jeweils eine Mehrzahl von Schwellenwerten hinterlegt sein, anhand derer die Steuerung 25 den erfassten Druckverlauf bewertet. Bei einer weiteren Ausgestaltung können in dem Speicher 27 für jeden von mehreren Bautypen von Selbstblasschaltern jeweils mehrere charakteristische transiente Druckverläufe hinterlegt sein. Die Steuerung 25 kann den erfassten Druckverlauf in der Zeitdomäne mit den im Speicher 27 hinterlegten charakteristischen transienten Druckverläufen vergleichen, um automatisch zu bestimmen, ob der Abbrand der Abbranddüse 11 so weit fortgeschritten ist, dass das Gehäuse 2 des Selbstblasschalters geöffnet werden muss.

Alternativ oder zusätzlich kann das mobile Messgerät 21 auch transienten Druckverläufe, die nach einem Schaltvorgang ohne elektrische Last in mehreren Wartungen an dem gerade geprüften Selbstblasschalter erfassten werden, archivieren. Eine Bewertung des erfassten Druckverlaufs zur Ermittlung des Düsenabbrands kann abhängig von einem Vergleich mit Druckverläufen erfolgen, die bei früheren Wartungen des Selbstblasschalters 1 erfasst wurden. Anhand der Veränderung des erfassten Druckverlaufs kann die Steuerung 25 auf einen zunehmenden Abbrand der Abbranddüse 11 rückschließen und automatisch bestimmen, ob die Schaltkammer des Selbstblasschalters 1 geöffnet werden muss. Bei einer derartigen Diagnose, die zumindest auch auf historischen Daten des jeweiligen Selbstblasschalters 1 beruht, kann der Benutzer über die Benutzerschnittstelle 29 Informationen eingeben, die den Selbstblasschalter 1 eindeutig identifizieren.

Falls mehrere Selbstblasschalter in einer Batterie mit einer gemeinsamen Füllöffnung kombiniert sind, kann die Steuerung 25 die Auswertung separat für jeden der mehreren Selbstblasschalter vornehmen. Die an der Füllöffnung im Inneren des Gehäuses vorherrschende Druckveränderung hängt im Allgemeinen davon ab, welcher der mehreren Selbstblasschalter in den offenen Zustand geschaltet wird, da die Druckwellen im Füllgas unterschiedliche Pfade von dem Düsenbereich des entsprechenden Selbstblasschalters bis zu der Füllöffnung zurücklegen müssen. Entsprechend können in dem Speicher 27 für jeden der mehreren Selbstblasschalter einer Batterie von Selbstblasschaltern Daten gespeichert sein, die eine Bewertung des Druckverlaufs, der als Reaktion auf einen Schaltvorgang des entsprechenden Selbstblasschalters an der Füllöffnung erfasst wird, erlaubt, um den Zustand der Abbranddüse des entsprechenden Selbstblasschalters zu ermitteln.

Die mobile Diagnosevorrichtung 20 kann weitere Komponenten aufweisen. Beginn und Ende eines Zeitintervalls, in dem aus dem transienten Druckverlauf im Inneren des Gehäuses 2 auf die Geometrie der Abbranddüse 11 rückgeschlossen werden kann, hängen davon ab, wann der Schaltvorgang ausgelöst wird. Zur Bestimmung dieses Zeitpunkts kann ein weiterer Sensor 23 oder können mehrere weitere Sensoren vorgesehen sein. Der weitere Sensor 23 kann einen Antrieb des Selbstblasschalters überwachen und/oder einen elektrischen Widerstand, Spannungsabfall oder Strom zwischen den Kontakten 3 und 4 messen. Der weitere Sensor 23 kann beispielsweise als Drehwinkelsensor ausgestaltet sein, der einen Drehwinkel der Antriebswelle 6 überwacht. Der weitere Sensor 23 kann lösbar mit einer weiteren Schnittstelle 28 des mobilen Messgeräts 21 gekoppelt sein. Die Steuerung 25 kann die von dem weiteren Sensor 23 erfassten Daten verwenden, um den Zeitpunkt einer Kontakttrennung der Kontakte 3 und 4 des Selbstblasschalters zu ermitteln. Diesen Zeitpunkt kann die Steuerung 25 nutzen, um eine Aufzeichnung eines Druckverlaufs zu beginnen und/oder um aus einem über einen längeren Zeitraum von dem Drucksensor 22 erfassten Druckverlauf einen Teil auszuwählen, der den transienten Druckverlauf nach dem Schaltvorgang repräsentiert und Informationen über den Abbrand der Abbranddüse 11 liefert.

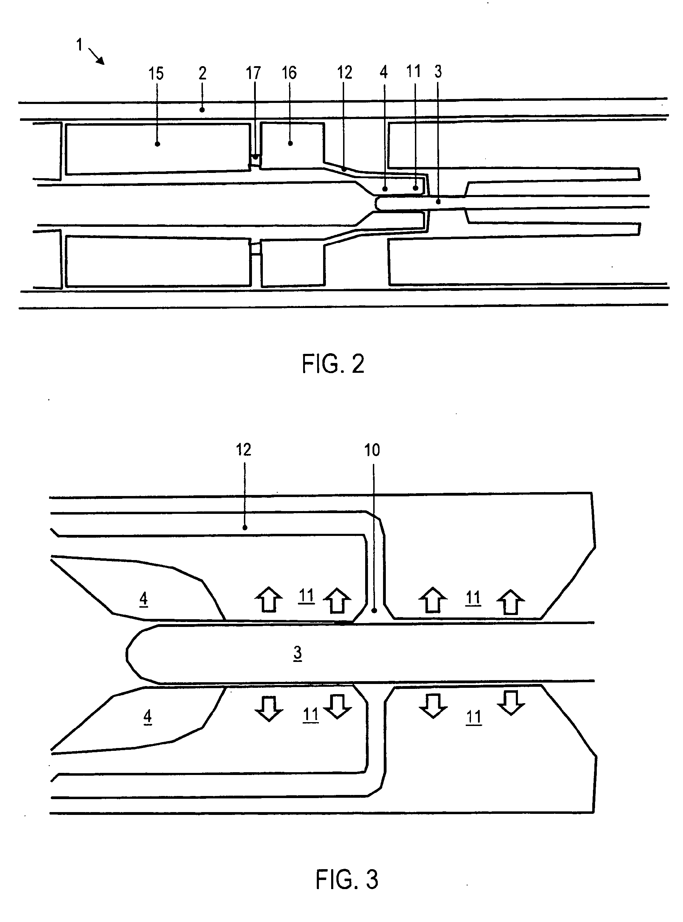

FIG. 2-4 veranschaulichen den Aufbau einer Löschkammer eines Selbstblasschalters, bei dem das Verfahren und die mobile Diagnosevorrichtung nach Ausführungsbeispielen einsetzbar sind. FIG. 2-4 zeigen dabei Querschnittsansichten entlang der Längsachse der Selbstblasschalters.

Im Inneren des Gehäuses 2 des Selbstblasschalters 1 sind ein Kompressionsvolumen 15 und ein Heizvolumen 16 vorgesehen. Das Kompressionsvolumen 15 und das Heizvolumen 16 können durch ein Rückschlagventil 17 verbunden sein. Das Kompressionsvolumen 15 und das Heizvolumen 16 sind Gasräume, die im Inneren des Gehäuses 2 gebildet sind. Die Kontakte des Schalters umfassen einen Fingerkontakt 4 und einen Kontaktstift 3. Andere Ausgestaltungen der Kontakte können verwendet werden. Die Abbranddüse 11, die aus einem Isolierstoff besteht, ist mit dem Fingerkontakt 4 verbunden. Das Heizvolumen 16 steht über einen Durchgang 12 in einer Fluidverbindung mit einer Öffnung 10, an der beispielsweise bei einer Kurzschlussabschaltung der Lichtbogen mit dem Füllgas beströmt werden kann. Je nach Bauart des Schalters können auch mehrere derartige Durchgänge 12 vorhanden sein.

Wird der Selbstblasschalter 1 in den offenen Zustand geschaltet, bewirkt die Schalthandlung eine Volumenverringerung des Kompressionsvolumens 15. Der Druck im Kompressionsvolumen 15 und Heizvolumen 16 steigt an. Wenn durch die Relativbewegung zwischen dem Fingerkontakt 4 und dem Kontaktstift 3 der Düsenbereich der Abbranddüse 11 freigegeben wird, setzt eine Strömung ein, bei der Gas über den Durchlass 12 in den Düsenbereich strömt. Bis zum Ende des Schaltvorgangs bildet sich ein Staupunkt an der Stelle aus, an der die Gasströmung aus dem Heizvolumen 16 über den Durchlass 12 in den Düsenbereich strömt. Auch in beabstandeten Bereichen Gasvolumens im Inneren 8 des Selbstblasschalters 1 führen die resultierenden Druckwellen im Füllgas zu einer transienten Druckveränderung. Diese kann an einer Messposition, beispielsweise an der Füllöffnung 9, überwacht werden.

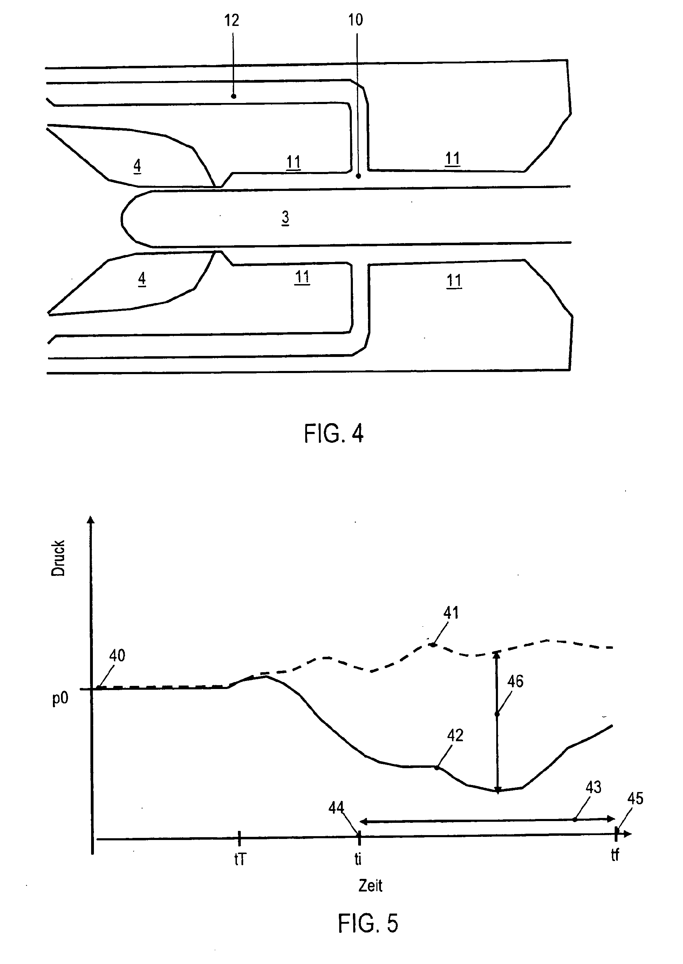

FIG. 3 und FIG. 4 zeigen eine vergrößerte Querschnittsansicht des Düsenbereichs, der von der Abbranddüse 11 gebildet wird. Wird der Selbstblasschalter 1 unter elektrischer Last in den offenen Zustand geschaltet, bewirkt ein zwischen den Kontakten 3 und 4 brennender Lichtbogen, dass die Abbranddüse 11 an ihrem radial inneren Bereich verdampft, um den Druckaufbau für das Beblasen des Lichtbogens mit dem Füllgas zu unterstützen. Durch das Abbrennen der Abbranddüse 11 weitet sich die Düsengeometrie radial, wie in FIG. 3 schematisch durch Pfeile dargestellt ist. FIG. 4 zeigt den Düsenbereich nach mehreren Schaltvorgängen unter Last. Die sich verändernde Düsengeometrie beeinflusst die Ausbreitung von Schallwellen oder anderen Druckwellen im Füllgas während eines Schaltvorgangs. Die abhängig vom Zustand der Abbranddüse 11 unterschiedlichen Druckverläufe, die beispielsweise an der Füllöffnung 9 im Gasvolumen beobachtet werden können, erlauben die Ermittlung des Zustands der Abbranddüse aus dem erfassten Druckverlauf.

FIG. 5 zeigt schematisch Druckverläufe, wie sie an einer Messposition des Selbstblasschalters 1 nach einem Schaltvorgang in den offenen Zustand ohne Last auftreten. Dabei entspricht der mit gestrichelter Linie dargestellte Druckverlauf 41 einem System ohne Düsenabbrand. Der mit durchgezogener Linie dargestellte Druckverlauf 42 entspricht einem System, bei dem die Abbranddüse 11 radial so abgebrannt ist, wie es bei typischen Selbstblasschaltern nach ungefähr acht Kurzschlussabschaltungen der Fall ist.

FIG. 5 zeigt den transienten Druckverlauf, der an einer von dem Düsenbereich des Selbstblasschalters beabstandeten Messposition resultiert. Die Messposition kann beispielsweise am axialen Ende des Selbstblasschalters angeordnet sein. Dargestellt ist das transiente Verhalten über einen Zeitraum von insgesamt 50 ms. Die dargestellten Druckverläufe wurden für einen typischen Fülldruck und eine typische Kontaktgeschwindigkeit beim Schaltvorgang ermittelt.

Der erfasste Druckverlauf an der Messposition, beispielsweise an der Füllöffnung 9, zeigt wesentliche Unterschiede abhängig davon, in welchem Umfang die Düse abgebrannt ist. Zu Beginn der Schalthandlung zeigen der transiente Druckverlauf 41 in einem Selbstblasschalter ohne Düsenabbrand und der transiente Druckverlauf 42 in einem Selbstblasschalter mit Düsenabbrand denselben Verlauf als Funktion der Zeit. Der Druckverlauf 41 in dem Selbstblasschalter ohne Düsenabbrand steigt anschließend und schwingt sich um einen erhöhten Wert ein. Der Druckverlauf 42 in dem Selbstblasschalter mit Düsenabbrand zeigt ein vollständig anderes Verhalten. Nach Erreichen eines ersten lokalen Maximums sinkt der Druck unter den Ausgangsdruck, der dem Fülldruck entspricht. Die Druckdifferenz zwischen den beiden Druckverläufen 41 und 42 erreicht im vorliegenden Beispiel einen bei 46 dargestellten Wert, der nach einer Zeit von einigen Millisekunden oder einigen zehn Millisekunden auftritt, beispielsweise nach etwa 40 ms. Erst im weiteren Verlauf steigt der Druckverlauf 42 in dem Selbstblasschalter mit Düsenabbrand an und nähert sich dem Druckverlauf 41 in dem Selbstblasschalter ohne Düsenabbrand.

Die Unterschiedlichen Druckverläufe können bei Verfahren und mobilen Diagnosevorrichtungen nach Ausführungsbeispielen automatisch erkannt werden. Dazu kann beispielsweise der Druckverlauf analysiert werden, der in einem Zeitintervall 43 nach Beginn der Schalthandlung erfasst wird. Verschiedene Verarbeitungsschritte können dazu durchgeführt werden, wie zeitliche Integration der Druckveränderung gegenüber dem Fülldruck, Spektralanalyse im Intervall 43 und/oder direkter Vergleich der Druckverläufe 41 und 42, die im Zeitintervall 43 erfasst werden. Eine Anfangszeit 44 und eine Endzeit 45 des Zeitintervalls können abhängig von dem Zeitpunkt tT festgelegt werden, bei dem die Kontakttrennung erfolgt. Der Elektrodenabbrand der Kontakte 3 und 4 des Selbstblasschalters kann dabei berücksichtigt werden. Alternativ oder zusätzlich kann das Zeitintervall 43 auch abhängig von der Schallgeschwindigkeit im Füllgas und abhängig von der Geometrie des Selbstblasschalters 1 festgelegt werden. Auf diese Weise kann die Laufzeit der Druckwellen vom Düsenbereich bis zur Messposition, d.h. beispielsweise bis zur Füllöffnung 9, berücksichtigt werden.

Unterschiedliche transiente Druckverläufe in Abhängigkeit vom Zustand der Abbranddüse können auch bei Variationen in den Parametern des Selbstblasschalters beobachtet werden, beispielsweise für unterschiedliche Fülldrücke, unterschiedliche Kontaktgeschwindigkeiten oder unterschiedlichen Elektrodenabbrand. Die Verfahren und Vorrichtungen nach Ausführungsbeispielen können somit auch unter Berücksichtigung von sich im Feldeinsatz ändernden Randbedingungen wie Fülldruckschwankungen, Elektrodenabbrand oder sich ändernden Kontaktgeschwindigkeiten eingesetzt werden. Während diese Parameter den als Reaktion auf einen Schaltvorgang ohne elektrische Last resultierenden Druckverlauf an der Messposition, beispielsweise an der Füllöffnung, nur schwach beeinflussen, zeigt der transiente Druckverlauf wesentliche Unterschiede in Abhängigkeit vom Düsenabbrand.

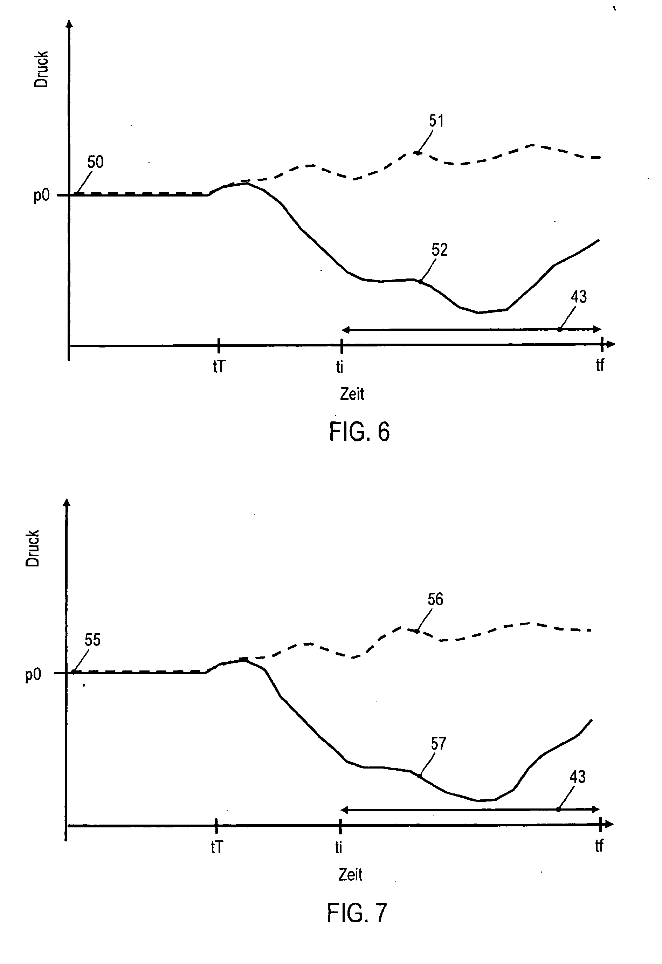

FIG. 6 und FIG. 7 zeigen Druckverläufe, die an einer Messposition des Selbstblasschalters 1 nach einem Schaltvorgang in den offenen Zustand ohne Last auftreten. Dabei entspricht der mit gestrichelter Linie dargestellte Druckverlauf 51 bzw. 56 einem System ohne Düsenabbrand. Der mit durchgezogener Linie dargestellte Druckverlauf 52 bzw. 57 entspricht einem System, bei dem die Abbranddüse 11 radial so abgebrannt ist, wie es bei typischen Selbstblasschaltern nach ungefähr acht Kurzschlussabschaltungen der Fall ist. Dargestellt ist das transiente Verhalten über einen Zeitraum von insgesamt 50 ms. Die Kurven wurden für eine typische Kontaktgeschwindigkeit beim Schaltvorgang ermittelt.

Im Unterschied zu den bei FIG. 5 dargestellten Druckverläufen sind die in FIG. 6 und FIG. 7 dargestellten Druckverläufe für andere Fülldrücke ermittelt. Der in FIG. 6 dargestellten Druckverlauf 51 für einen Selbstblasschalter ohne Düsenabbrand und der Druckverlauf 52 für einen Selbstblasschalter mit Düsenaufweitung wurden für einen Fülldruck 50 ermittelt, der größer als der Fülldruck 40 in FIG. 4 ist. Der in FIG. 7 dargestellten Druckverlauf 56 für einen Selbstblasschalter ohne Düsenabbrand und der Druckverlauf 57 für einen Selbstblasschalter mit Düsenaufweitung wurden für einen Fülldruck 55 ermittelt, der größer als der Fülldruck 40 in FIG. 4 und als der Fülldruck 50 in FIG. 5 ist.

Die wesentlichen unter Bezugnahme auf FIG. 5 erläuterten Unterschiede im Druckverlauf abhängig vom Zustand der Abbranddüse können für verschiedene Fülldrücke beobachtet werden. Der erfasste Druckverlauf für ein System ohne oder mit geringem Düsenabbrand kann zuverlässig vom erfassten Druckverlauf für ein System mit stärkerem Düsenabbrand, beispielsweise nach mehreren Kurzschlussabschaltungen, unterschieden werden. Eine nicht-invasive Bestimmung des Düsenabbrands anhand des erfassten Druckverlaufs ist robust gegenüber Variationen des Fülldrucks.

Eine Änderung der Kontaktgeschwindigkeit, mit der die Kontakte 3 und 4 des Selbstblasschalters bei dem Schaltvorgang relativ zueinander bewegt werden, kann das Verhalten des transienten Druckverlaufs an der Messposition beeinflussen. Die charakteristischen Unterschiede, die im transienten Druckverlauf als Reaktion auf einen Schaltvorgang zwischen einem Selbstblasschalter ohne Düsenabbrand und einem Selbstblasschalter mit Düsenabbrand bestehen, können für unterschiedliche Kontaktgeschwindigkeiten beobachtet werden.

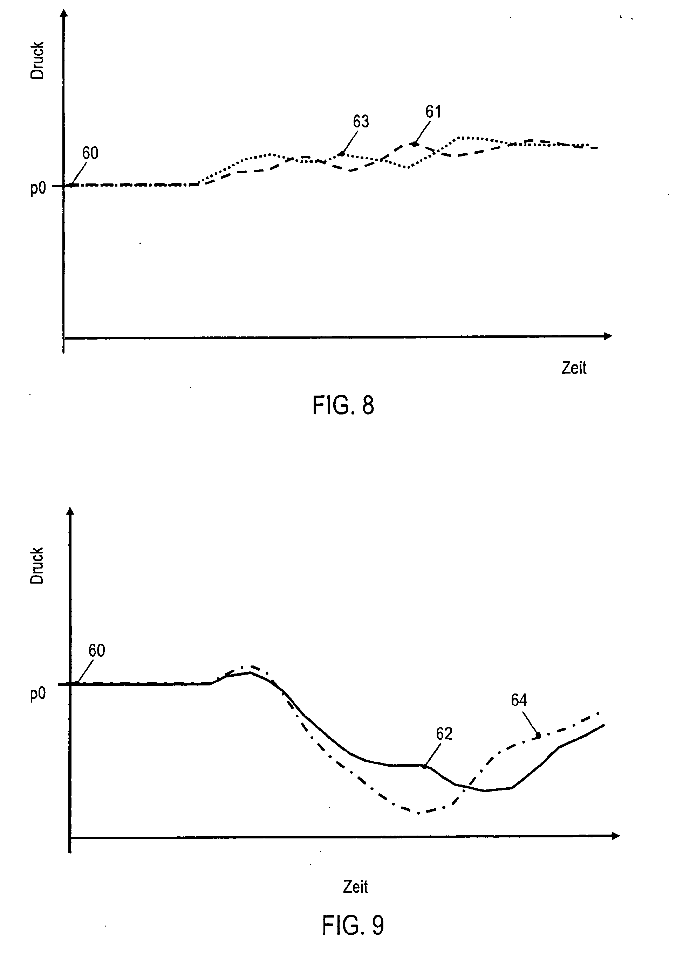

FIG. 8 und FIG. 9 veranschaulichen den transienten Druckverlauf an der Messposition, wenn die Schalthandlung mit unterschiedlichen Kontaktgeschwindigkeiten erfolgt. Dargestellt ist das transiente Verhalten über einen Zeitraum von insgesamt 50 ms. Die Druckverläufe wurden für einen typischen Fülldruck 60 ermittelt.

FIG. 8 zeigt den transienten Druckverlauf an der Messposition für einen Selbstblasschalter ohne Düsenabbrand. Der gestrichelt dargestellte Druckverlauf 61 an der Messposition wurde für eine typische Kontaktgeschwindigkeit beim Schaltvorgang bestimmt. Der gepunktet dargestellte Druckverlauf 63 an der Messposition wurde für eine Kontaktgeschwindigkeit bestimmt, die etwa 40% größer als die Kontaktgeschwindigkeit im Druckverlauf 61 ist.

FIG. 9 zeigt den transienten Druckverlauf an der Messposition für einen Selbstblasschalter mit Düsenabbrand, der zu einer Aufweitung des Düsendurchmessers um 4 mm geführt hat. Der mit durchgezogener Linie dargestellte Druckverlauf 62 an der Messposition wurde für eine typische Kontaktgeschwindigkeit beim Schaltvorgang bestimmt. Der mit strichpunktierter Linie dargestellte Druckverlauf 64 an der Messposition wurde für eine Kontaktgeschwindigkeit bestimmt, die etwa 40% größer als die Kontaktgeschwindigkeit im Druckverlauf 62 ist.

Die Kontaktgeschwindigkeit beeinflusst den an der Messposition erfassten zeitabhängigen Druck. Bei einem Selbstblasschalter ohne Düsenabbrand zeigt der Druckverlauf 61 für eine niedrigere Kontaktgeschwindigkeit zunächst einen weniger starken Anstieg als der Druckverlauf 63 für eine höhere Kontaktgeschwindigkeit. In beiden Fällen zeigt der Druckverlauf Schwingungen und pendelt sich schließlich bei einem erhöhten Wert ein. Bei einem Selbstblasschalter mit Düsenabbrand zeigt der Druckverlauf 64 für eine höhere Kontaktgeschwindigkeit zunächst einen stärkeren Anstieg als der Druckverlauf 62, der für die niedrigere Kontaktgeschwindigkeit ermittelt wird. Auch der anschließende Druckabfall ist im Druckverlauf 64 für die höhere Kontaktgeschwindigkeit stärker ausgeprägt und erfolgt schneller als im Druckverlauf 62 für die niedrigere Kontaktgeschwindigkeit.

Trotz des Einflusses, den die Kontaktgeschwindigkeit des Selbstblasschalters auf den transienten Druckverlauf an der Messposition hat, bleiben die charakteristischen Unterschiede zwischen dem transienten Druckverlauf bei einem Selbstblasschalter ohne oder mit geringem Düsenabbrand und einem Selbstblasschalter mit stärkerem Düsenabbrand bestehen. Eine nicht-invasive Bestimmung des Düsenabbrands anhand des erfassten Druckverlaufs kann zuverlässig auch bei Selbstblasschaltern mit unterschiedlichen Kontaktgeschwindigkeiten durchgeführt werden.

Weitere Untersuchungen an Selbstblasschaltern zeigen, dass ein Elektrodenabbrand des ersten Kontakts 3 und/oder des zweiten Kontakts 4 des Selbstblasschalters 1 die an der Messposition erfassten Druckverläufe nur schwach beeinflusst. Die charakteristischen Unterschiede, die im transienten Druckverlauf als Reaktion auf einen Schaltvorgang zwischen einem Selbstblasschalter ohne Düsenabbrand und einem Selbstblasschalter mit Düsenabbrand bestehen, können auch dann beobachtet werden, wenn sich durch Elektrodenabbrand die Kontakte 3 und 4 des Selbstblasschalters 1 verändern. Eine nicht-invasive Bestimmung des Düsenabbrands anhand des erfassten Druckverlaufs kann zuverlässig auch bei Selbstblasschaltern durchgeführt werden, die unterschiedlichen Elektrodenabbrand aufweisen.

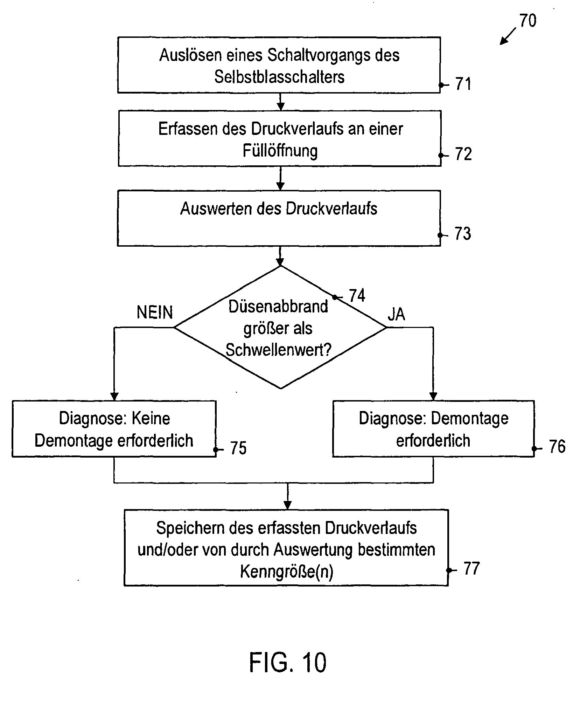

FIG. 10 ist ein Flussdiagramm eines Verfahrens 70 nach einem Ausführungsbeispiel. Das Verfahren kann von der mobilen Diagnosevorrichtung 20, die unter Bezugnahme auf FIG. 1 erläutert wurde, automatisch durchgeführt werden. Das Verfahren 70 kann bei einer Wartung des montierten Selbstblasschalters durchgeführt werden. Dazu kann die mobile Diagnosevorrichtung 20 am Selbstblasschalter installiert werden, nachdem der Selbstblasschalter freigeschaltet wurde.

Bei 71 wird ein Schaltvorgang des Selbstblasschalters ohne elektrische Last ausgelöst. Bei dem Schaltvorgang kann der Selbstblasschalter von dem geschlossenen Zustand in den offenen Zustand geschaltet werden.

Bei 72 wird ein zeitabhängiger Druckverlauf, der als Reaktion auf den Schaltvorgang entsteht, an einer Messposition erfasst. Die Messposition kann eine Füllöffnung zum Befüllen des Selbstblasschalters mit Füllgas sein.

Bei 73 wird der erfasste Druckverlauf ausgewertet. Dazu kann der in der Zeitdomäne erfasste Druckverlauf mit wenigstens einer Referenzkurve verglichen werden, die in der mobilen Diagnosevorrichtung 20 hinterlegt ist, um den Zustand der Abbranddüse zu ermitteln. Alternativ oder zusätzlich kann der Druckverlauf, der in einem Zeitintervall nach Auslösen des Schaltvorgangs erfasst wird, verschiedenen Datenverarbeitungsprozeduren unterzogen werden, um den Zustand der Abbranddüse zu ermitteln. Beispielsweise kann eine Druckveränderung gegenüber einem Fülldruck in dem Zeitintervall über die Zeit integriert werden, um zuverlässig zu ermitteln, ob sich der Druck an der Messposition während des Zeitintervalls erhöht oder erniedrigt. Alternativ oder zusätzlich kann ein Frequenzspektrum des Druckverlaufs ermittelt werden, das der Druckverlauf während des Zeitintervalls aufweist. Anfangs- und Endzeitpunkt des Zeitintervalls, für das der transiente Druckverlauf ausgewertet wird, können abhängig vom Zeitpunkt der Kontakttrennung des Selbstblasschalters bei dem Schaltvorgang, der bei 71 ausgelöst wird, festgelegt werden. Die Schaltergeometrie und Schallgeschwindigkeit im Füllgas können bei der Festlegung des Zeitintervalls berücksichtigt werden. Der Anfangszeitpunkt des relevanten Zeitintervalls, in dem der erfasste Druck zuverlässig Auskunft über den Düsenabbrand geben kann, kann ermittelt werden aus dem Zeitpunkt der Kontakttrennung und der Laufzeit der Druckwelle, die von der Schallgeschwindigkeit und der Weglänge zwischen Düsenbereich und Messposition abhängt. Der transiente Druckverlauf an der Messposition, der Auskunft über den Düsenabbrand geben kann, kann in einer Zeit von einigen zehn Millisekunden bis einigen Sekunden abklingen. Entsprechend kann das Zeitintervall, für das der transiente Druckverlauf ausgewertet wird, eine Dauer von weniger als einer Sekunde, insbesondere von weniger als 500 ms, insbesondere von weniger als 100 ms aufweisen. Eine Beobachtung und Auswertung des Druckverlaufs kann auch über längere Zeitintervalle erfolgen. Wie unter Bezugnahem auf FIG. 5-9 beschrieben wurde, kann jedoch ein Rückschluss auf den Zustand der Abbranddüse bereits aus dem transienten Verhalten gezogen werden, das beispielsweise in einem Zeitraum von 50 ms beobachtet werden kann.

Bei 74-76 kann abhängig von der Auswertung des Druckverlaufs bei 73 ermittelt werden, welchen Zustand die Abbranddüse aufweist. Dabei kann, wie für das Verfahren 70 dargestellt, wenigstens ermittelt werden, ob eine Demontage des Selbstblasschalters erforderlich ist. Bei 74 kann ermittelt werden, ob der Düsenabbrand größer als ein Schwellenwert ist. Dazu kann eine bei 73 aus dem transienten Druckverlauf bestimmte Kenngröße mit einem Schwellenwert verglichen werden.

Falls bei 74 ermittelt wird, dass der Düsenabbrand noch nicht so weit fortgeschritten ist, dass eine Schaltkammer des Selbstblasschalters für eine Sichtprüfung der Abbranddüse geöffnet werden muss, kann bei 75 ein entsprechendes Diagnoseergebnis ausgegeben werden. Beispielsweise kann über eine Benutzerschnittstelle eine Information ausgegeben werden, dass keine Demontage des Selbstblasschalters erforderlich ist.

Falls bei 74 ermittelt wird, dass der Düsenabbrand so weit fortgeschritten ist, dass eine Schaltkammer des Selbstblasschalters für eine Sichtprüfung der Abbranddüse geöffnet werden muss, kann bei 76 ein entsprechendes Diagnoseergebnis ausgegeben werden. Beispielsweise kann über eine Benutzerschnittstelle eine Information ausgegeben werden, dass der Selbstblasschalter demontiert werden muss.

Bei 77 kann eine Protokollierung der Druckverlaufsmessung durch die mobile Diagnosevorrichtung erfolgen. Dazu kann der erfasste transiente Druckverlauf an der Messposition nach Auslösen des Schaltvorgangs und/oder eine aus dem transienten Druckverlauf ermittelte Kenngröße in einem Speicher der mobilen Diagnosevorrichtung gespeichert werden. Die Druckverlaufmessung und/oder das zugehörige Protokoll kann archiviert werden.

Die mobile Diagnosevorrichtung kann nach Durchführung des Verfahrens von dem Selbstblasschalter entfernt und zur erneuten Durchführung des Verfahrens an einem weiteren Selbstblasschalter montiert werden. So kann für mehrere Selbstblasschalter bei der Wartung der entsprechenden Selbstblasschalter jeweils der Zustand der Abbranddüse ermittelt werden.

Während Ausführungsbeispiele unter Bezugnahme auf die Figuren beschrieben wurden, können Abwandlungen bei weiteren Ausführungsbeispielen realisiert sein.

Beispielsweise können die Verfahren und mobilen Diagnosevorrichtungen auch eingesetzt werden, wenn mehrere Selbstblasschalter in einer Anordnung bzw. "Batterie" von Selbstblasschaltern kombiniert sind, die eine gemeinsame Füllöffnung und/oder eine gemeinsame Antriebswelle aufweist. In diesem Fall werden die unterschiedlichen Schalter durch die Antriebswelle parallel in den offenen Zustand geschaltet. Der an der Füllöffnung als Messposition jeweils gemessene transiente Druckverlauf kann ausgewertet werden, um für jeden der mehrere Selbstblasschalter den Zustand der Abbranddüse zu ermitteln.

Weitere Sensoren können verwendet werden, um die Diagnose des Selbstblasschalters vorzunehmen. Beispielsweise kann ein Widerstand, Spannungsabfall oder Strom zwischen den Kontakten des Selbstblasschalters gemessen werden, um den Zeitpunkt zu bestimmen, bei dem die Kontakttrennung erfolgt. Abhängig von dem so bestimmten Zeitpunkt kann eine Aufzeichnung des Druckverlaufs, der an der Messposition erfasst wird, ausgelöst und/oder ein Zeitintervall festgelegt werden, für das der erfasste Druckverlauf weiter ausgewertet wird.

Während die Diagnose so durchgeführt werden kann, dass nur ermittelt wird, ob der Selbstblasschalter demontiert und das Gehäuse für eine Prüfung der Abbranddüse geöffnet werden soll, kann die Diagnose den Zustand der Abbranddüse auch quantitativ bestimmen. Beispielsweise kann der transiente Druckverlauf, der bei der Diagnose an der Messposition erfasst wird, auch ausgewertet werden, um daraus den Düsenabbrand quantitativ zu bestimmen. Dazu kann ein Vergleich mit Kennfeldern oder anderen Tabellen erfolgen, in denen für den jeweiligen Bautyp des Selbstblasschalters die resultierenden Druckverläufe abhängig vom Düsenabbrand hinterlegt sind.

Mit Hilfe von Verfahren und Diagnosevorrichtungen nach Ausführungsbeispielen lässt sich der Zustand der Abbranddüse eines Selbstblasschalters nicht-invasiv im Rahmen einer Wartung am Selbstblasschalter bestimmen. Eine zeit- und kostenintensive Öffnung des Gehäuses des Selbstblasschalters in einer Werkstatt kann somit vermieden werden. Die Verfahren und Diagnosevorrichtungen stellen ein Mittel zur Verfügung, mit dem die Lebenserwartung bzw. Zeit bis zur nächsten Revision eines Selbstblasschalters zuverlässig bestimmt und hierdurch eine effiziente Nutzung des Selbstblasschalters im elektrischen Energieversorgungsnetz gewährleistet werden kann.

Selbstblasleistungsschalter werden heute weithin in den elektrischen Energieversorgungsnetzen der Hoch- und Höchstspannungsebene verwendet. Ausführungsbeispiele der Erfindung können somit die Wartungs- und Instandhaltungsstrategie von Energieversorgern bzw. Netzbetreibern unterstützen.

## Patentansprüche

1. Verfahren zur Diagnose eines Selbstblasschalters (1), wobei das Verfahren umfasst:
- Auslösen eines Schaltvorgangs des Selbstblasschalters (1), um eine Druckwelle in einem Füllgas des Selbstblasschalters (1) auszulösen,
- Erfassen eines zeitabhängigen Druckverlaufs (41, 42; 51, 52; 56, 57; 61-64) in wenigstens einem Bereich des Selbstblasschalters (1) als Reaktion auf den Schaltvorgang, und
- Ermitteln eines Zustands einer Abbranddüse (11) des Selbstblasschalters (1), die bei einem Schaltvorgang unter Last zum Beblasen eines Schaltlichtbogens mit dem Füllgas abgebrannt wird, wobei der Zustand der Abbranddüse (11) in Abhängigkeit von dem zeitabhängigen Druckverlauf (41, 42; 51, 52; 56, 57; 61-64) ermittelt wird.

2. Verfahren nach Anspruch 1,
wobei der Zustand der Abbranddüse (11) abhängig von einer transienten Druckveränderung in dem zeitabhängigen Druckverlauf (41, 42; 51, 52; 56, 57; 61-64), die als Reaktion auf den Schaltvorgang in einem Zeitintervall (43) erfasst wird, bestimmt wird.

3. Verfahren nach Anspruch 2,
wobei der zeitabhängige Druckverlauf (41, 42; 51, 52; 56, 57; 61-64) an einer Füllöffnung (9) des Selbstblasschalters (1) zum Nachfüllen des Füllgases erfasst wird, die von der Abbranddüse (11) beabstandet ist.

4. Verfahren nach Anspruch 2 oder Anspruch 3, wobei das Verfahren weiterhin umfasst:
- Erfassen einer Kontakttrennung von Kontakten (3, 4) des Selbstblasschalters (1),
wobei das Zeitintervall (43) abhängig von einem Zeitpunkt, bei dem die Kontakttrennung erfolgt, festgelegt wird.

5. Verfahren nach Anspruch 4,
wobei zum Erfassen der Kontakttrennung ein mechanischer Antrieb (5, 6) des Selbstblasschalters (1) und/oder eine elektrische Verbindung der Kontakte (3, 4) des Selbstblasschalters (1) überwacht wird.

6. Verfahren nach einem der Ansprüche 2 bis 5,
wobei das Verfahren weiterhin umfasst:
- Erfassen eines Drucks (40; 50; 60) und einer Temperatur des Füllgases vor dem Auslösen des Schaltvorgangs,
wobei das Zeitintervall (43) abhängig von dem Druck (40; 50; 60) und der Temperatur des Füllgases, die vor dem Auslösen des Schaltvorgangs erfasst werden, festgelegt wird.

7. Verfahren nach Anspruch 6,
wobei das Zeitintervall (43) weiterhin abhängig von einer Geometrie des Selbstblasschalters (1) festgelegt wird.

8. Verfahren nach einem der Ansprüche 2 bis 7,
wobei der Zustand der Abbranddüse (11) abhängig von einem Zeitintegral der erfassten transienten Druckveränderung ermittelt wird.

9. Verfahren nach einem der vorhergehenden Ansprüche,
wobei der Zustand der Abbranddüse (11) abhängig von wenigstens einer Spektralkomponente des erfassten zeitabhängigen Druckverlaufs (41, 42; 51, 52; 56, 57; 61-64) ermittelt wird.

10. Verfahren nach einem der vorhergehenden Ansprüche, wobei das Verfahren weiterhin umfasst:
- Empfangen einer Benutzereingabe mit Informationen, die dem Selbstblasschalter zugeordnet sind,
wobei der Zustand der Abbranddüse (11) in Abhängigkeit von dem zeitabhängigen Druckverlauf (41, 42; 51, 52; 56, 57; 61-64) und in Abhängigkeit von einer Datenbankabfrage, die basierend auf der Benutzereingabe durchgeführt wird, ermittelt wird.

11. Verfahren nach einem der vorhergehenden Ansprüche,
wobei der ermittelte Zustand der Abbranddüse (11) ausgewählt ist aus einem ersten Zustand, der einen weiteren Betrieb des Selbstblasschalters (1) erlaubt, und einem zweiten Zustand, der eine Sichtüberprüfung der Abbranddüse (11) des Selbstblasschalters (1) erfordert.

12. Diagnosevorrichtung für Selbstblasschalter (1), umfassend:
- eine Schnittstelle (26) zum Empfangen von Druckdaten, die einen zeitabhängigen Druckverlauf (41, 42; 51, 52; 56, 57; 61-64) in wenigstens einem Bereich des Selbstblasschalters (1) als Reaktion auf einen Schaltvorgang des Selbstblasschalters (1) angeben, und
- eine Steuerung (25), die mit der Schnittstelle (26) gekoppelt und eingerichtet ist, um einen Zustand einer Abbranddüse (11) des Selbstblasschalters (1), die bei einem Schaltvorgang unter Last abgebrannt wird, in Abhängigkeit von den Druckdaten zu ermitteln.

13. Diagnosevorrichtung nach Anspruch 12, umfassend:
einen mit der Schnittstelle koppelbaren Drucksensor (22), wobei der Drucksensor (22) eine Kopplungsstruktur (24) aufweist, die zur Befestigung an einer Füllöffnung (9) des Selbstblasschalters (1) eingerichtet ist.

14. Diagnosevorrichtung nach Anspruch 12 oder Anspruch 13, umfassend:
einen Drehwinkelsensor (23) zum Erfassen eines Drehwinkels einer Antriebswelle (5) des Selbstblasschalters (1),
wobei die Steuerung (25) mit dem Drehwinkelsensor (23) gekoppelt und eingerichtet ist, um abhängig von einer Druckveränderung in einem Zeitintervall (43), das von dem erfassten Drehwinkel abhängt, den Zustand der Abbranddüse (11) zu ermitteln.

15. Diagnosevorrichtung nach einem der Ansprüche 12 bis 14, die als mobile Diagnosevorrichtung ausgestaltet ist und die zur Durchführung des Verfahrens nach einem der Ansprüche 1 bis 11 eingerichtet ist.

## Claims

1. Method of diagnosing a self-blast circuit breaker (1), the method comprising:
- triggering a switching operation of the self-blast circuit breaker (1) to initiate a pressure wave in a filling gas of the self-blast circuit breaker (1),
- detecting a pressure as a function of time (41, 42; 51, 52; 56, 57; 61-64) in at least one region of the self-blast circuit breaker (1) in response to the switching operation, and
- determining a state of a burn-off nozzle (11) of the self-blast circuit breaker (1) which is burnt off in a switching operation under load for blowing filling gas onto a switching arc, the state of the burn-off nozzle (11) being determined in dependence on the pressure as a function of time (41, 42; 51, 52; 56, 57; 61-64).

2. Method of claim 1,
wherein the state of the burn-off nozzle (11) is determined based on a transient pressure variation in the pressure as a function of time (41, 42; 51, 52; 56, 57; 61-64), which is detected in response to the switching operation in a time interval (43).

3. Method of claim 2,
wherein the pressure as a function of time (41, 42; 51, 52; 56, 57; 61-64) is detected at a filling port (9) of the self-blast circuit breaker (1) for refilling the filling gas, which is spaced from the burn-off nozzle (11).

4. Method of claim 2 or claim 3, the method further comprising:
- detecting a contact separation of contacts (3, 4) of the self-blast circuit breaker (1),
the time interval (43) being set in dependence on a time at which the contact separation takes place.

5. Method of claim 4,
wherein a mechanical drive (5, 6) of the self-blast circuit breaker (1) and/or an electric connection of the contacts (3, 4) of the self-blast circuit breaker (1) is monitored to detect the contact separation.

6. Method of any one of claims 2 to 5, the method further comprising:
- detecting a pressure (40; 50; 60) and a temperature of the filling gas before the switching operation is triggered,
the time interval (43) being set in dependence on the pressure (40; 50; 60) and the temperature of the filling gas detected prior to triggering the switching operation.

7. Method of claim 6,
the time interval (43) being set further in dependence on a geometry of the self-blast circuit breaker (1).

8. Method of any one of claims 2 to 7,
wherein the state of the burn-off nozzle (11) is determined in dependence on a time integral of the detected transient pressure variation.

9. Method of any one of the preceding claims,
wherein the state of the burn-off nozzle (11) is determined in dependence on at least one spectral component of the detected pressure as a function of time (41, 42; 51, 52; 56, 57; 61-64).

10. Method of any one of the preceding claims, the method further comprising:
- receiving a user input with information associated with the self-blast circuit breaker,
wherein the state of the burn-off nozzle (11) is determined in dependence on the pressure as a function of time (41, 42; 51, 52; 56, 57; 61-64) and in dependence on a database query which is performed based on the user input.

11. Method of any one of the preceding claims,
wherein the determined state of the burn-off nozzle (11) is selected from a first state, which allows operation of the self-blast circuit breaker (1) to be continued, and a second state, which requires a visual inspection of the burn-off nozzle (11) of the self-blast circuit breaker (1) to be carried out.

12. Diagnostic device for a self-blast circuit breaker (1), comprising:
- an interface (26) for receiving pressure data which indicate a pressure as a function of time (41, 42; 51, 52; 56, 57; 61-64) in at least one region of the self-blast circuit breaker (1) in response to a switching operation of the self-blast circuit breaker (1), and
- a control (25) coupled to the interface (26) and configured to determine, in dependence on the pressure as a function of time, a state of the blow-off nozzle (11) of the self-blast circuit breaker (1) which is burnt off in a switching operation under load.

13. Diagnostic device of claim 12, comprising:
a pressure sensor (22) configured to be coupled to the interface, the pressure sensor (22) having a coupling structure (24) configured for mounting to a filling port (9) of the self-blast circuit breaker (1).

14. Diagnostic device of claim 12 or claim 13, comprising:
a rotation angle sensor (23) for detecting a rotation angle of a drive shaft (5) of the self-blast circuit breaker (1),
the control (25) being coupled to the rotation angle sensor (23) and being configured to determine the state of the burn-off nozzle (11) in dependence on a pressure variation in a time interval (43) which is a function of the rotation angle.

15. Diagnostic device of any one of claims 12 to 14, which is configured as a mobile diagnostic device and which is configured to perform the method according to any one of claims 1 to 11.

## Revendications

1. Procédé pour le diagnostic d'un disjoncteur à auto-soufflage (1), dans lequel le procédé comprend :
- le déclenchement d'un processus de commutation du disjoncteur à auto-soufflage (1) afin de déclencher une onde de pression dans un gaz de remplissage du disjoncteur à auto-soufflage (1),
- la détection d'une variation de pression dans le temps (41, 42 ; 51, 52 ; 56, 57 ; 61-64) dans au moins une zone du disjoncteur à auto-soufflage (1) en tant que réaction au processus de commutation, et
- la détermination d'un état d'une buse combustible (11) du disjoncteur à auto-soufflage (1), laquelle est brûlée lors d'un processus de commutation sous charge pour le soufflage d'un arc de coupure avec le gaz de remplissage, dans lequel l'état de la buse combustible (11) est déterminé en fonction de la variation de pression dans le temps (41, 42 ; 51, 52 ; 56, 57 ; 61-64).

2. Procédé selon la revendication 1,
dans lequel l'état de la buse combustible (11) est déterminé en fonction d'une modification de pression transitoire dans la variation de pression dans le temps (41, 42 ; 51, 52 ; 56, 57 ; 61-64), laquelle est déterminée en tant que réaction au processus de commutation dans un intervalle de temps (43).

3. Procédé selon la revendication 2,
dans lequel la variation de pression dans le temps (41, 42 ; 51, 52 ; 56, 57 ; 61-64) est détectée au niveau d'une ouverture de remplissage (9) du disjoncteur à auto-soufflage (1) pour faire l'appoint en gaz de remplissage, laquelle ouverture est espacée par rapport à la buse combustible (11).

4. Procédé selon la revendication 2 ou la revendication 3, dans lequel le procédé comprend en outre :
- la détection d'une isolation de contacts de contacts (3, 4) du disjoncteur à auto-soufflage (1),
dans lequel l'intervalle de temps (43) est déterminé en fonction d'un moment où l'isolation de contacts a lieu.

5. Procédé selon la revendication 4,
dans lequel, pour détecter l'isolation de contacts, une commande mécanique (5, 6) du disjoncteur à auto-soufflage (1) et/ou une connexion électrique des contacts (3, 4) du disjoncteur à auto-soufflage (1) sont surveillées.

6. Procédé selon l'une des revendications 2 à 5,
dans lequel le procédé comprend en outre :
- la détection d'une pression (40 ; 50 ; 60) et d'une température du gaz de remplissage avant le déclenchement du processus de commutation,
dans lequel l'intervalle de temps (43) est déterminé en fonction de la pression (40 ; 50 ; 60) et de la température du gaz de remplissage, lesquelles sont détectées avant le déclenchement du processus de commutation.

7. Procédé selon la revendication 6,
dans lequel l'intervalle de temps (43) est en outre déterminé en fonction d'une géométrie du disjoncteur à auto-soufflage (1).

8. Procédé selon l'une des revendications 2 à 7,
dans lequel l'état de la buse combustible (11) est déterminé en fonction d'une intégrale dans le temps du changement de pression transitoire détecté.

9. Procédé selon l'une des revendications précédentes,
dans lequel l'état de la buse combustible (11) est déterminé en fonction d'au moins une composante spectrale de la variation de pression dans le temps (41, 42 ; 51, 52 ; 56, 57 ; 61-64) détectée.

10. Procédé selon l'une des revendications précédentes, dans lequel le procédé comprend en outre :
- la réception d'une entrée d'utilisateur avec des informations, lesquelles sont associées au disjoncteur à auto-soufflage,
dans lequel l'état de la buse combustible (11) est déterminé en fonction de la variation de pression dans le temps (41, 42 ; 51, 52 ; 56, 57 ; 61-64) et en fonction de l'interrogation d'une base de données, laquelle est effectuée sur la base de l'entrée d'utilisateur.

11. Procédé selon l'une des revendications précédentes,
dans lequel l'état déterminé pour la buse combustible (11) est choisi parmi un premier état qui autorise une poursuite du fonctionnement du disjoncteur à auto-soufflage (1) et un deuxième état qui nécessite un contrôle visuel de la buse combustible (11) du disjoncteur à auto-soufflage (1).

12. Dispositif de diagnostic pour disjoncteur à auto-soufflage, comprenant :
- une interface (26) pour réceptionner des données de pression, lesquelles indiquent une variation de pression dans le temps (41, 42 ; 51, 52 ; 56, 57 ; 61-64) dans au moins une zone du disjoncteur à auto-soufflage (1) en tant que réaction à un processus de commutation du disjoncteur à auto-soufflage (1), et
- une commande (25), laquelle est couplée avec l'interface (26) et est étudiée pour déterminer un état d'une buse combustible (11) du disjoncteur à auto-soufflage (1), laquelle est brûlée lors d'un processus de commutation sous charge, en fonction des données de pression.

13. Dispositif de diagnostic selon la revendication 12, comprenant :
un capteur de pression (22) pouvant être couplé avec l'interface, dans lequel le capteur de pression (22) présente une structure de couplage (24), laquelle est étudiée pour la fixation à une ouverture de remplissage (9) du disjoncteur à auto-soufflage (1).

14. Dispositif de diagnostic selon la revendication 12 ou la revendication 13, comprenant :
un capteur d'angle de rotation (23) pour détecter un angle de rotation d'un arbre d'entraînement (5) du disjoncteur à auto-soufflage (1),
dans lequel la commande (25) est couplée avec le capteur d'angle de rotation (23) et est étudiée pour déterminer l'état de la buse combustible (11) en fonction d'un changement de pression dans un intervalle de temps (43) qui dépend de l'angle de rotation détecté.

15. Dispositif de diagnostic selon l'une des revendications 12 à 14, lequel est réalisé en tant que dispositif de diagnostic mobile et lequel est étudié pour la mise en oeuvre du procédé selon l'une des revendications 1 à 11.
